# EUROPEAN PATENT APPLICATION

(11) **EP 1 848 262 A1**
(43) Date of publication of application: **24.10.2007**
(21) Application number: 06007962.1
(22) Date of filing: 18.04.2006
(51) Int. Cl.: H05K 13/08

(54) **Virtual mounter system**

(71) Applicant: Mirae Corporation, Chonan-si Chungchongnam-do (KR)
(72) Inventor: Jung, Yun Gi, Gunpo-si, Gyeonggi-do (KR); Kim, Young Joo, Mabuk-ri Guseong-eup Yongin-si Gyeonggi- (KR); Hwang, Heung Seon, Cheonan-si, Chungcheongnam-do (KR)
(74) Representative: Zech, Stefan Markus

(57) **Abstract**

A virtual mounter system is disclosed. The system can implement a mounter through an animation model or a simulation model before users substantially access a real mounter. The system can allow users to learn a necessary technology related to drive and maintenance of a mounter thorough animation or simulation for the mounter. The system can support driving environment of a real mounter to users as examples of setup and motions are displayed. The system can show contents (an assembly structure of a mounter, functions of each assembly, an operation sequence and an operation method) which is described in a user's manual for a mounter, in real time, through an animation model or a simulation model of the mounter.

## Description

This application claims the benefit of the Korean Patent Application No.10-2004-0083190, filed on October 18, 2004, which is hereby incorporated by reference as if fully set forth herein.

### BACKGROUND OF THE INVENTION

### Field of the Invention

The present invention relates to a mounter system, and more particularly, to a virtual mounter system which is capable of implementing a mounter through an animation model or a simulation model before users substantially access a real mounter.

### Discussion of the Related Art

Generally, a mounter is indicative of equipment which automatically mounts parts, such as various chips, resisters, capacitors, transistors, etc., on a certain circuit board.

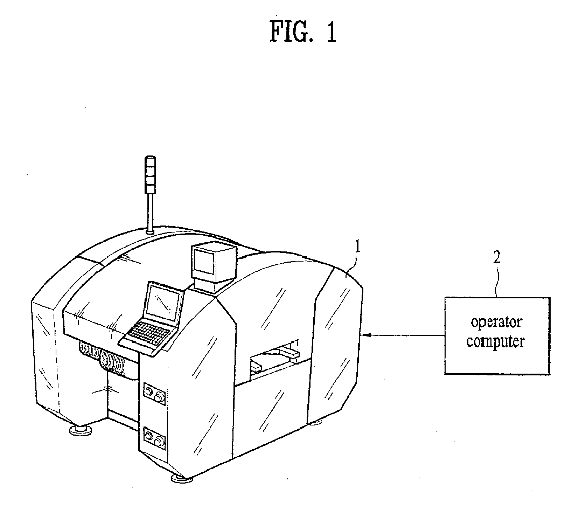

FIG. 1 illustrates a schematic diagram of a conventional mounter, which includes machine 1 and an operator computer 2.

The machine 1 is actually operated to mount real parts thereon.

The operator computer 2 executes driving control of the machine 1. Therefore, an operator can controls starting, driving and administration of the machine 1 throng an operation program included in the operator computer 2.

On the other hand, experts who operate and administrate the mounter are recently further needed. In the light with, there is no economy in preparing the real mounter for educating only the experts, because it is substantially expensive.

Furthermore, when a newly developed mounter is sold on the market, users have difficulty to learn the whole operations (the machine and the operation program thereof). Namely, the mounter user must sufficiently learn a manual for the newly developed mounter, such that he/she can skillfully process operations and maintenance of the newly developed mounter to prevent break down and damage of the mounter when the mounter is operated.

However, at the present stage, since a manual including structures and functions for the whole apparatus is proved, the conventional method requires much education time until users skillfully deal with or maintain a new mounter.

### SUMMARY OF THE INVENTION

Accordingly, the present invention is directed to a virtual mounter system that substantially obviates one or more problems due to limitations and disadvantages of the related art.

An object of the present invention is to provide a virtual mounter system which is capable of allowing users to learn a necessary technology related to drive and maintenance of a mounter thorough animation or simulation for the mounter.

Another object of the present invention is to provide a virtual mounter system which is capable of supporting driving environment of a real mounter to users as examples of setup and motions are displayed.

A further object of the present invention is to provide a virtual mounter system which is capable of showing contents (an assembly structure of a mounter, functions of each assembly, an operation sequence and an operation method) which is described in a user's manual for a mounter, in real time, through an animation model or a simulation model of the mounter.

Additional advantages, objects, and features of the invention will be set forth in part in the description which follows and in part will become apparent to those having ordinary skill in the art upon examination of the following or may be learned from practice of the invention. The objectives and other advantages of the invention may be realized and attained by the structure particularly pointed out in the written description and claims hereof as well as the appended drawings.

To achieve these objects and other advantages and in accordance with the purpose of the invention, as embodied and broadly described herein, a virtual mounter system including: a mounter for mounting parts on a circuit board; and an operator computer including at least one program which executes driving control of the mounter, and motion control of an animation model or a simulation model, which figures configuration of the mounter in a multi-dimension.

Preferably, the program provides a graphic user interface for performing driving control of the mounter and motion control of the animation model and the simulation model.

Preferably, the program includes: an operation program for executing driving control of the mounter; and a simulation program for executing motion control of the animation model and the simulation model associating with the operation program. Here, the operation program includes a plurality of commands for performing driving control of the mounter, wherein the plurality of commands includes commands for executing motion control of the animation model and the simulation model.

Preferably, the simulation program moves a previously prepared animation model to virtually display motions that the mounter performs manufacturing processes, if the commands for the driving control correspond to the manufacturing processes by the mounter. Here, the simulation program further displays a form of a finished product according to the result of the manufacturing processes of the mounter as a animation model.

Preferably, the commands for the driving control are to dissemble and/or assemble of the mounter, the simulation program moves a previously prepared animation model to virtually display sequential motion for the dissemble and/or sequential motion for the assemble.

Preferably, when the commands for the driving control is a structure of the mounter and positions of assemblies included in the mounter, the simulation program virtually displays appearances of the mounter and the assemblies included in the mounter, mounted positions of the assemblies, motions for mounting sequence of the assemblies or motions for dissembling sequence of the assemblies, using a previously prepared animation model.

Preferably, when the commands for the driving control is an operation of the assembly included in the mounter, the simulation program virtually displays the motions of a corresponding assembly, using a previously prepared animation model of the corresponding assembly.

Preferably, when the commands for the driving control include a parameter which is used in manufacturing processes for producing the product of the mounter, the simulation program controls the simulation model according to the value of the parameter. Here, the parameter corresponds to input data which are required in the manufacturing processes when the parts are absorbed or installed. Here, the input data includes: data indicative of information of size and type of a circuit board used in the manufacturing processes; data indicative of information of speed and width of a conveyor conveying the circuit board; data indicative of parts absorption positions of a feeder used when the parts are absorbed; data indicative of information size and type of a nozzle used when the parts are absorbed or mounted; and data indicative of a position of each axis of a gantry used when the parts are absorbed or mounted and a speed of the gantry in each axis when the parts are absorbed or mounted.

Preferably, the operation program further comprises commands for additionally controlling one of magnification, reduction, and rotation while motions of the animation model and the simulation model are preformed according to motion control for the models.

In another aspect of the present invention, a virtual mounter system comprises: real operation equipment including a mounter composing of a plurality of assemblies and a operator computer for performing driving control of the mounter; and virtual operation equipment including a simulation computer for executing simulation for the mounter according to the driving control of the mounter from the operator computer.

Preferably, the simulation computer includes multi-dimensional simulation models of the mounter and executes simulation according to the driving control of the mounter, using the simulation models.

Preferably, the simulation computer includes simulation models for assembly structure of the mounter, driving of the assemblies, parts used for the mounter, and products produced by the mounter.

Preferably, the simulation models for each structure of the assemblies of the mounter perform dissembling or assembling in a predetermined sequence.

Preferably, the simulation models for driving the assemblies move in a sequence to produce a product using simulation models for each structure of the assemblies of the mounter and simulation models for parts used in the mounter.

In further aspect of the present invention, a virtual mounter system comprises: a mounter; an operator computer including an operation program for executing driving control of the mounter; a simulation computer including a simulation program for executing simulation for the mounter, commonly using an interface for performing driving control of the mounter; and a display block which provides a graphic user interface for manipulating the operation program and displays the simulation execution.

Preferably, the operator computer further includes at least one interface module for commonly transmitting driving control of the operation program to the mounter and the simulation computer.

Preferably, the simulation computer includes multi-dimensional animation models of the assemblies included in the mounter and multi-dimensional animation models of parts which are provided in order to produce a product, wherein the animation models perform simulation according to command values of driving control of the mounter.

In yet another aspect of the present invention, a virtual mounter system comprises: a mounter composing of a plurality of assemblies; a first computer composing of and animation model of the mounter, a simulation model of the mounter, and a first program for performing animation using the animation model and simulation using the simulation model; and a second computer including a second program for providing executing commands, which correspond to the animation and the simulation, to the first computer.

Preferably, the animation model and/or the simulation model, which are operated according to the executing commands of the second program, are moved similar to the motion of the mounter according to the executing commands.

Preferably, the second computer commonly uses an interface for motions of the animation model and/or the simulation model and an interface for motions of the mounter.

It is to be understood that both the foregoing general description and the following detailed description of the present invention are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this application, illustrate embodiment(s) of the invention and together with the description serve to explain the principle of the invention. In the drawings:

FIG. 1 illustrates a schematic diagram of a conventional mounter;

FIG. 2 illustrates a virtual mounter system according to a first embodiment of the present invention;

FIG. 3 illustrates a virtual mounter system according to a second embodiment of the present invention; and

FIG. 4 to FIG. 7 illustrates examples of animation models and simulation models, which are used in a virtual mounter system according to the present invention.

### DETAILED DESCRIPTION OF THE INVENTION

Reference will now be made in detail to the preferred embodiments of the present invention, examples of which are illustrated in the accompanying drawings. Wherever possible, the same reference numbers will be used throughout the drawings to refer to the same or like parts.

A virtual mounter system according to the preferred embodiment of the present invention will be described in detail below.

The virtual mounter system of the present invention discloses contents of a user's manual of a mounter (i.e., structure/position/operation/motion of an assembly for a mounter, functions of each assembly, an operation sequence and an operation method), manufacturing processes for producing products, forms of products proceeded by each assembly in manufacturing processes, a dissembling sequence and an assembling sequence of a mounter, which are shown by an animation model or a simulation model.

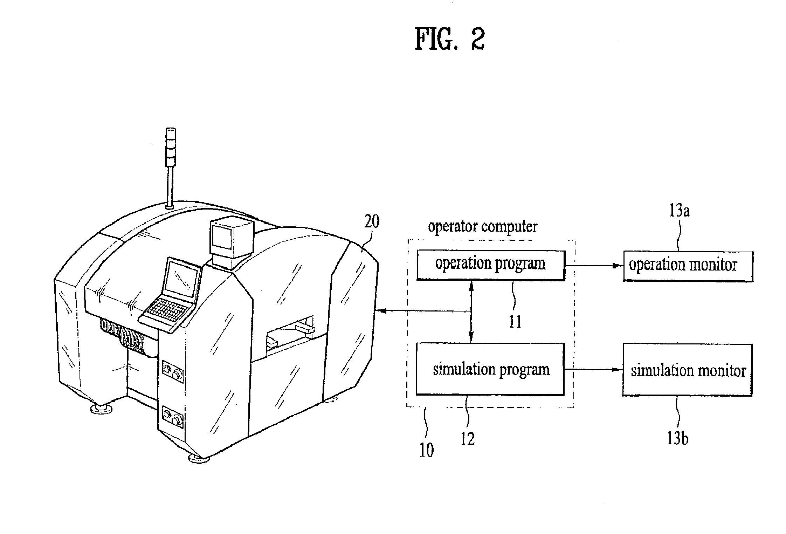

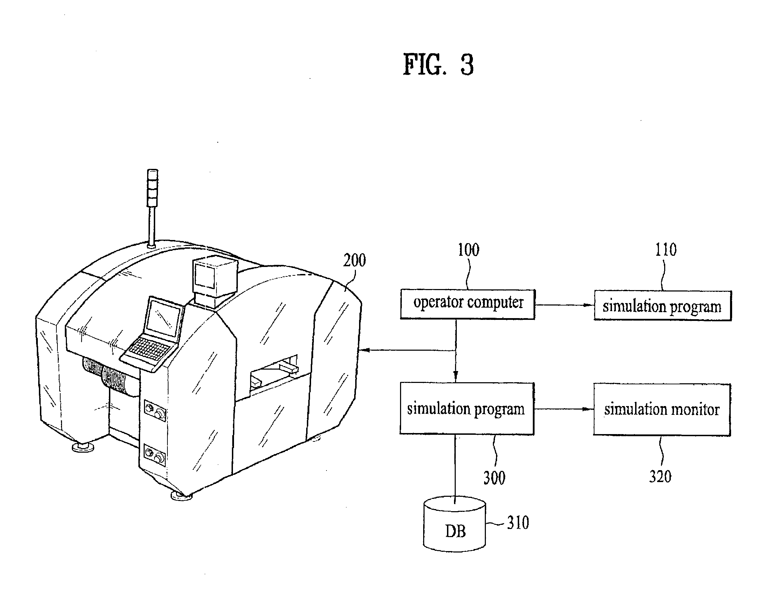

The virtual mounter system of the present invention is configured as shown in FIG. 2 or FIG. 3.

FIG. 2 illustrates a virtual mounter system according to a first embodiment of the present invention.

Referring to FIG. 2, the virtual mounter system includes an operator computer 10, a mounter 20, an operation monitor 13a, and a simulation monitor 13b.

The operator computer 10 includes an operation program 11. and a simulation program 12.

The operation program 11 is a program to execute driving control of the conventional mounter.

The simulation program 12 executes motion control of an animation model and a simulation model, associating with the operation program 11.

The mounter 20 is equipment for substantially mounting electrical parts on a circuit board.

The operation monitor 13a displays operation environment of the operation program 11, and the simulation monitor 13b displays operation environment of the simulation program 12.

The operator computer 10 executes driving control of the mounter 20 through the operation program 11.
Especially, the operation program 11 provides a graphic user interface (GUI) for driving control of the mounter 20.

Such driving control of the mounter 20, which is executed by the GUI, can be applied to the animation model and the simulation model such that the models can be moved (animated/simulated).

More specifically, the operation program 11 employs a plurality of commands for driving control of the mounter 20.

The commands for driving control of the mounter 20 may further include commands for motion control of the animation model and simulation model, which are controlled by the simulation program 12.

The commands for motion control of the animation model and simulation model are applied to a real mounter 20 such that the real mounter 20 can be operated.

For example, a motion of the animation model (or a simulation model) according to one command shows a simulation motion of multi-dimensions for a real mounter 20, which is implemented with the same command.

In other words, the operator computer 10 executes motion control of an animation model and a simulation model, which are formed as forms of the real mounter 20 are simulated in multi-dimensions by the simulation program 12, associating with the operation program 11. At the same time, the real mounter 20 are motioned like an animation model corresponding thereto (or a simulation model corresponding thereto), according to commands which are the same commands as the motion controls of the models.

The following is a description for several embodiments in which the operation program 11 transmits commands for motion control of the mounter 2o to the simulation program 12.

Firstly, when the commands for the driving control correspond to a manufacturing process for producing a product of the mounter 20, the simulation program 12 moves an animation model which is previously prepared therein. Therefore, motions for the manufacturing process of the product of the mounter 20 are virtually displayed on the simulation monitor 13b.

Especially, the simulation program 12 may further display a form of a finished product of the mounter 20 as a certain animation model, after the manufacturing process for the product of the real mounter 20 is performed.

When the commands for the driving control are a manufacturing process for producing a product of the mounter 20, including a parameter value used in the manufacturing process, the simulation program 12 does not control the animation model but controls the simulation model according to the parameter value. Therefore, the corresponding simulation model is displayed through the simulation monitor 13b. The parameter value is indicative of data which is inputted by an operator through the GUI of the operation program 11. Especially, the parameter is input data which is required when electrical parts are absorbed or mounted on a circuit board in the production manufacturing process.

Here, the input data includes: data indicative of information of size and type of a circuit board used in the manufacturing process; data indicative of information of speed and width of a conveyor conveying the circuit board; data indicative of parts absorption positions of a feeder used when the parts (various chips, resisters, capacitors, transistors, etc.) are absorbed in the circuit board; data indicative of information size and type of a nozzle used when the parts are absorbed or mounted; and data indicative of positions of X-, Y- and Z-axes of a gantry used when the parts are absorbed or mounted, and a speed of the gantry in each axis when the parts are absorbed or mounted. The input data is not limited by the above-listed, instead it may include all data whose values can be changed as an operator inputs values to the data in a procedure of motion control of the real mounter 20.

Secondly, if the commands for the driving control serve to assemble and/or dissemble the mounter 20, the simulation program 12 moves an animation model which is previously prepared to virtually display sequential motions of the dissemble procedure and/or sequential motions of the assemble procedure.

Thirdly, when the commands for the driving control are whole or partial structure of the mounter 20 and positions of assemblies included in the mounter 20, the simulation program 12 virtually displays the whole or partial appearances of the mounter 20 and the assemblies included in the mounter 20, using an animation model which is previously prepared. Also, the simulation program 12 virtually displays appearances of assemblies included in the mounter 20, positions where the assemblies are mounted on the mounter 20, motions of a mounting sequence of the assemblies or of a dissembling sequence of the assemblies, using a previously prepared animation model.

Fourth, when the commands for the driving control are a motion of the assembly included in the mounter, the simulation program 12 virtually displays the motions of a corresponding assembly, using a previously prepared animation model of the corresponding assembly.

While animation or simulation is performed according to drive control commands, or while motions of the animation model and the simulation model are preformed according to motion control commands, the operation program may further include commands for additionally controlling one of magnification, reduction, and rotation thereof.

The operator computer 10 of the present invention includes animation models and simulation models which are in multi-dimensions, based on various cases. Here, the models are previously produced.

The operator computer 10 includes multi-dimensional animation or simulation models, which are simulated from a form of the mounter 20, such that animation or simulation is performed under driving control of the mounter, using the animation model or the simulation model.

For example, the operator computer 10 includes simulation models which are previously prepared, in which the simulation models are produced from structures of a plurality of assemblies, parts used in the mounter 20 when the assemblies are driven and the product of the mounter 20 is produced, and products produced by the mounter 20. Especially, the simulation model for the structure of each of the assemblies is produced such that it can be dissembled or assembled in a predetermined sequence. Therefore, the operator can virtually configure a complete mounter using the simulation model for each of the assemblies. Also, since the simulation model corresponding to the structure of the complete mounter is composed of models for a plurality of assemblies, each assembly can be separated one by one. Such a dissembling process can be virtually proceeded on the monitor.

The simulation model for drives of the assemblies is moved in a product producing sequence using simulation models for the structure of each of the assemblies of the mounter 20 and simulation models for parts which are used to produce the product of the mounter 20.

Also, the mounter 20 inputs a command for motion control from an operation program 11 included in the operator computer 10, analyzes the commands and drives each assembly based on the analysis result.

The mounter 20 composed of a plurality of assemblies is equipment which substantially mounts parts on circuit boards, such as a printed wiring board (PWB).

For example, when the assemblies of the mounter 20 are grouped, they can be classified into a base frame, a PWB transfer block, a component feeding block, and a part positioning block.

The base frame is a single assembly supporting the whole of the parts positioning block.

The PWB transfer block is classified into an inlet conveyor, a working conveyor, and an outlet conveyor. The inlet conveyor receives the PWB and then conveys the PWB to a parts mounting work position in the work conveyor. The work conveyor is operated such that the PWB arrived at a predetermined working position is stopped by a stopper and then fixed thereto by a fixing plate, a spring push up device, and a vacuum absorption device, etc. When the parts mounting work is finished, the outlet conveyor coveys the PWB to the next process.

The component feeding block includes a feeder base and a feeder.

The component positioning block includes an XY gantry, a vision system, a positioning head, an automatic nozzle changer (ANC), and nozzles. The XY gantry includes a common Y-axis slide (or a Y-frame), and two X-axis frames which are capable of being moved along the Y-axis slide. The automatic nozzle changer serves to contain additionally required nozzles such that corresponding nozzle can be automatically exchanged while the system is not stopped, when a new nozzle is used in each positioning head. On the other hand, the nozzles have a plurality of types.

The operator computer 10 of the present invention includes animation models or simulation models for the above-listed assemblies of the mounter 20, respectively, such that the animation models or simulation models of the assemblies can be assembled to virtually create a form of the complete mounter.

Also, the operator computer 10 includes simulation models for various types of nozzles. In addition, the operator computer 10 updates information related to new nozzles. Also, the operator computer 10 includes simulation models for parts provided to the mounter 20 to finish a product of the mounter 20, based on types of the simulation models. Here, the parts include various chips, resistors, capacitors, transistors, etc. Also, the operator computer 10 includes simulation models of nozzles which are applied to parts, associating with the parts.

And, the operator computer 10 includes an interface module for transmitting driving control of the operation program 11 to the mounter 20. Especially, the various motions of the animation or simulation models are controlled by the driving control of the operation program 11.

FIG. 3 illustrates a virtual mounter system according to a second embodiment of the present invention. The second embodiment of FIG. 3 is modified from the first embodiment of FIG. 2 as the operation program 11 and the simulation program 12 in the operator computer 10 are separated with respect to its hardware, in order to execute driving control of the mounter 200. Here, the simulation program serves to execute motion control of the animation and simulation models, associating with the operation program.

Namely, an operator 100 includes an operation program for driving control of a mounter 200, and a simulation computer 300 includes a simulation program for motion control of the animation model and the simulation model.

An operation monitor 110 displays operation environment of the operation program. And a simulation monitor 320 displays operation environment of the simulation program.

The simulation computer 300 includes a simulation database (DB) 310 in which the above- described various animation models and simulation models are stored.

The configuration of FIG. 3 shows real operation equipment for the mounter 200 and virtual operation equipment using a simulation model which is simulated from a form of the mounter 200.

Namely, the real operation equipment includes a mounter 200 composed of a plurality of assemblies, an operator computer 100 for driving control of the mounter 200, and a display block which provides a graphic user interface for dealing with an operation program included in the operator computer 100.

The virtual operation equipment includes a simulation computer 300 for executing animation or simulation for the mounter 200 under driving operation of the operator computer 100, and a display block for displaying animation or simulation.

The above-described two equipments are not independently operated, but operated together. Especially, the operator computer 100 of the real operation equipment provides commands for motion control to the virtual operation equipment.

In the virtual mounter system of the present invention, the operator computer 100 includes at least one interface module (not shown) to transmit the driving control of the operation program to the mounter 200 and the simulation computer 300, simultaneously. In other words, an interface for driving control of the mounter 200 is commonly used to perform animation or simulation for the mounter 200.

Also, the simulation DB 310 includes multi-dimensional animation models of assemblies included in the mounter 200 and multi-dimensional animation models of parts which are provided to produce a certain product. The animation models perform simulation based on a command value according to driving control of the mounter 200, which is transmitted from the operator computer 200.

The operation program included in the operator computer 100 works together with the simulation program included in the simulation computer 300 to perform various animation or simulation works.

The operation program includes program menus for supporting the various animation or simulation works. The program menus include menus for inputting data, which are required in manufacturing process when parts are absorbed or installed. Values of data are inputted thereto through the menu, in which the data includes: data indicative of information of size and type of a circuit board used in the manufacturing processes; data indicative of information of speed and width of a conveyor conveying the circuit board; data indicative of parts absorption positions of a feeder used when the parts are absorbed; data indicative of information size and type of a nozzle used when the parts are absorbed or mounted; and data indicative of a position of each axis of a gantry used when the parts are absorbed or mounted and a speed of the gantry in each axis when the parts are absorbed or mounted.

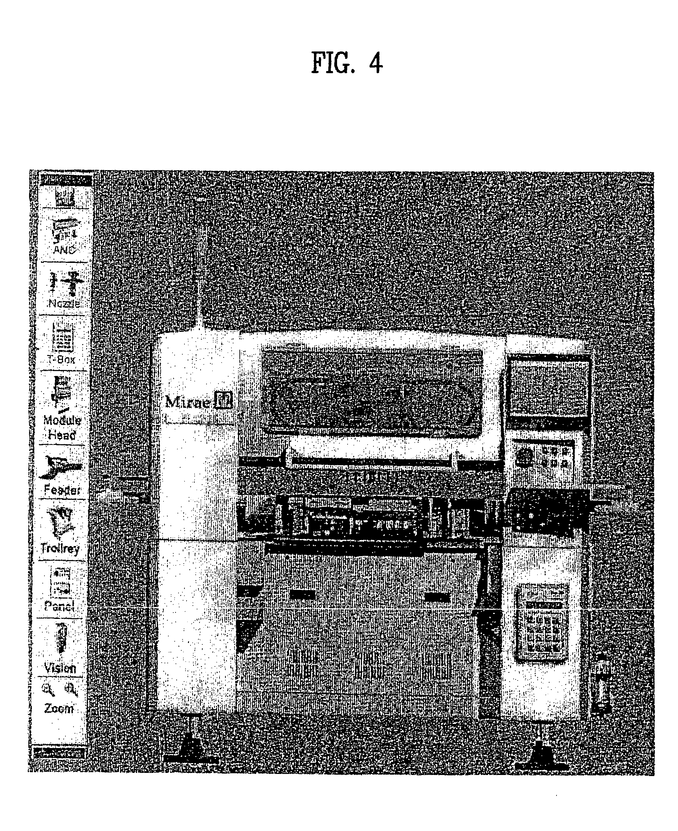

FIG. 4 to FIG. 7 illustrates examples of animation models and simulation models, which are used in a virtual mounter system according to the present invention.

More specifically, FIG. 4 illustrates a model showing the form of whole mounter.

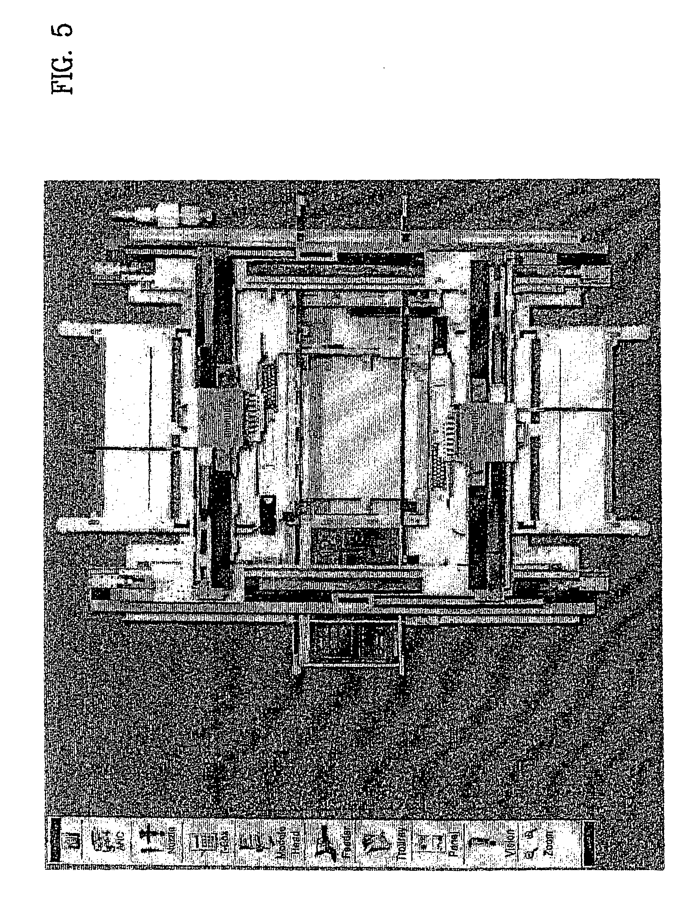

FIG. 5 illustrates a model after an operator drives parts of assembly, according to his/her desire, in the animation model of FIG. 4.

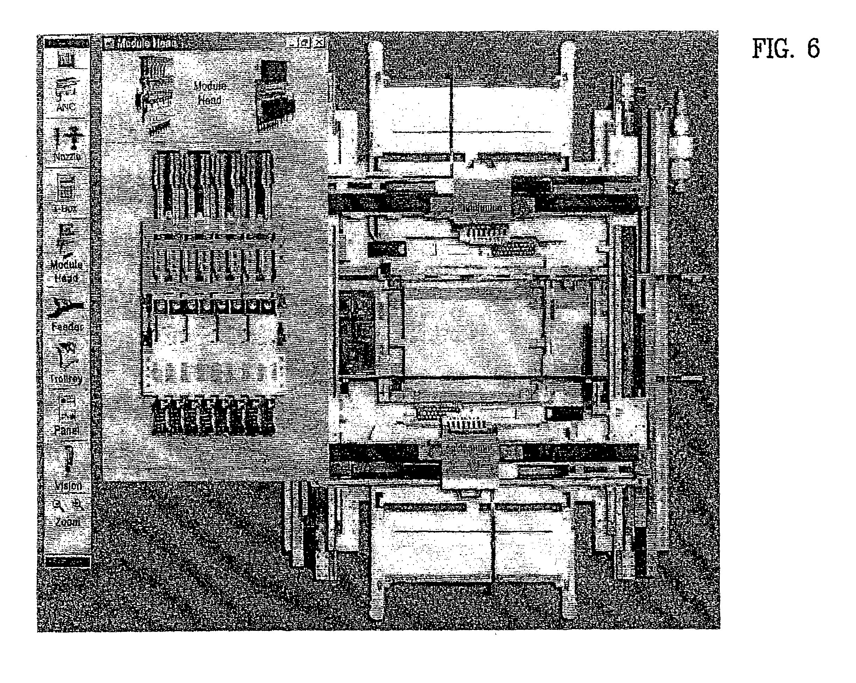

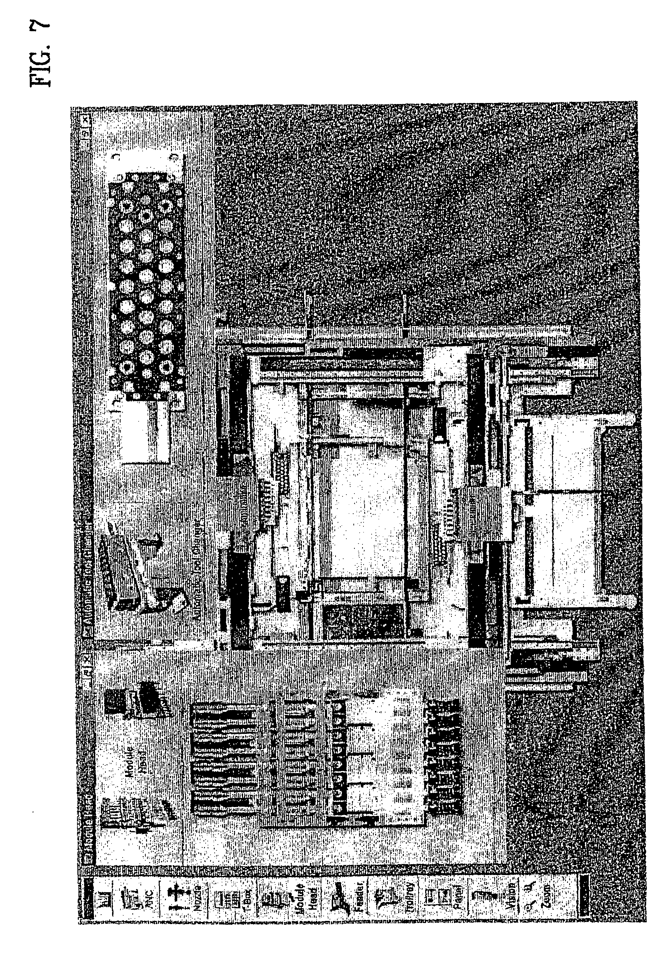

FIG. 6 and FIG. 7 illustrate enlarged models after only an assembly is magnified in the animation model.

The motions of the animation model or the simulation model, which are described above, can be shown on a display means, such as a monitor.

According to the present invention, it allows users to access and learn a technology for driving and maintenace of a mounter in a relatively short period, without use of a real mounter which is relatively expensive.

Also, since the present invention can provide driving environments of a mounter, which is similar to that of a real mounter, and contents (an assembly structure of a mounter, functions of assemblies, operation sequence and operation method) described in a manual of the mounter to users through a animation or simulation model, in real time, it can provide usefulness of driving and maintenance for the mounter equipment to users.

A platform for a new model of a mounter can be easily prepared based on the virtual mounter system of the present invention.

It will be apparent to those skilled in the art that various modifications and variations can be made in the present invention without departing from the spirit or scope of the inventions. Thus, it is intended that the present invention covers the modifications and variations of this invention provided they come within the scope of the appended claims and their equivalents.

## Claims

1. A virtual mounter system comprising:
a mounter for mounting parts on a circuit board; and
an operator computer including at least one program which executes driving control of the mounter, and motion control of an animation model or a simulation model, which figures configuration of the mounter in a multi-dimension.

2. The system of claim 1, wherein the program provides a graphic user interface for performing driving control of the mounter and motion control of the animation model and the simulation model.

3. The system of claim 1, wherein the program includes:
an operation program for executing driving control of the mounter; and
a simulation program for executing motion control of the animation model and the simulation model associating with the operation program.

4. The system of claim 3, wherein the operation program includes a plurality of commands for performing driving control of the mounter, wherein the plurality of commands includes commands for executing motion control of the animation model and the simulation model.

5. The system of claim 4, wherein the simulation program moves a previously prepared animation model to virtually display motions that the mounter performs manufacturing processes, if the commands for the driving control correspond to the manufacturing processes by the mounter.

6. The system of claim 5, wherein the simulation program further displays a form of a finished product according to the result of the manufacturing processes of the mounter as a animation model.

7. The system of claim 4, wherein, when the commands for the driving control is to dissemble and/or assemble of the mounter, the simulation program moves a previously prepared animation model to virtually display sequential motion for the dissemble and/or sequential motion for the assemble.

8. The system of claim 4, wherein, when the commands for the driving control are a structure of the mounter and positions of assemblies included in the mounter, the simulation program virtually displays appearances of the mounter and the assemblies included in the mounter, mounted positions of the assemblies, motions for mounting sequence of the assemblies or motion for dissembling sequence of the assemblies, using a previously prepared animation model.

9. The system of claim 4, wherein, when the commands for the driving control are an operation of the assembly included in the mounter, the simulation program virtually displays the motions of a corresponding assembly, using a previously prepared animation model of the corresponding assembly.

10. The system of claim 4, wherein, when the commands for the driving control include a parameter which is used in manufacturing processes for producing the product of the mounter, the simulation program controls the simulation model according to the value of the parameter.

11. The system of claim 10, wherein the parameter corresponds to input data which are required in the manufacturing processes when the parts are absorbed or installed.

12. The system of claim 11, wherein the input data includes:
data indicative of information of size and type of a circuit board used in the manufacturing processes;
data indicative of information of speed and width of a conveyor conveying the circuit board;
data indicative of parts absorption positions of a feeder used when the parts are absorbed;
data indicative of information size and type of a nozzle used when the parts are absorbed or mounted; and
data indicative of a position of each axis of a gantry used when the parts are absorbed or mounted and a speed of the gantry in each axis when the parts are absorbed or mounted.

13. The system of claim 4, wherein the operation program further comprises commands for additionally controlling one of magnification, reduction, and rotation while motions of the animation model and the simulation model are preformed according to motion control for the models.

14. A virtual mounter system comprising:
real operation equipment including a mounter composing of a plurality of assemblies and a operator computer for performing driving control of the mounter; and
virtual operation equipment including a simulation computer for executing simulation for the mounter according to the driving control of the mounter from the operator computer.

15. The system of claim 14, wherein the simulation computer includes multi-dimensional simulation models of the mounter and executes simulation according to the driving control of the mounter, using the simulation models.

16. The system of claim 15, wherein the simulation computer includes simulation models for assembly structure of the mounter, driving of the assemblies, parts used for the mounter, and products produced by the mounter.

17. The system of claim 16, wherein the simulation models for each structure of the assemblies of the mounter perform dissembling or assembling in a predetermined sequence.

18. The system of claim 17, wherein the simulation models for driving the assemblies move in a sequence to produce a product using simulation models for each structure of the assemblies of the mounter and simulation models for parts used in the mounter.

19. A virtual mounter system comprising:
a mounter;
an operator computer including an operation program for executing driving control of the mounter;
a simulation computer including a simulation program for executing simulation for the mounter, commonly using an interface for performing driving control of the mounter; and
a display block which provides a graphic user interface for manipulating the operation program and displays the simulation execution.

20. The system of claim 19, wherein the operator computer further includes at least one interface module for commonly transmitting driving control of the operation program to the mounter and the simulation computer.

21. The system of claim 20, wherein the simulation computer includes multi-dimensional animation models of the assemblies included in the mounter and multi-dimensional animation models of parts which are provided in order to produce a product, wherein the animation models perform simulation according to command values of driving control of the mounter.

22. A virtual mounter system comprising:
a mounter composing of a plurality of assemblies;
a first computer composing of an animation model of the mounter, a simulation model of the mounter, and a first program for performing animation using the animation model and simulation using the simulation model; and
a second computer including a second program for providing executing commands, which correspond to the animation and the simulation, to the first computer.

23. The system of claim 22, wherein the animation model and/or the simulation model, which are operated according to the executing commands of the second program, are moved similar to the motion of the mounter according to the executing commands.

24. The system of claim 23, wherein the second computer commonly uses an interface for motions of the animation model and/or the simulation model and an interface for motions of the mounter.
